# EUROPEAN PATENT APPLICATION

(11) **EP 3 032 243 A1**
(43) Date of publication of application: **15.06.2016**
(21) Application number: 14197210.9
(22) Date of filing: 10.12.2014
(51) Int. Cl.: G01N 21/956, G01N 21/84, G01N 23/205, G03F 1/00, G03F 1/84

(54) **Method and system for optical sample inspection using coherent diffraction imaging and a-priori knowledge of the sample**

(71) Applicant: Paul Scherrer Institut, 5232 Villigen (CH)
(72) Inventor: Ekinci, Yasin, 8046 Zürich (CH)
(74) Representative: Fischer, Michael

(57) **Abstract**

The present invention discloses a method and a system for reflective and scanning CDI for the identification of defects (4) in an actual pattern (6) of a sample (2) as compared to the desired pattern of the sample (2), comprising:
a) providing the sample (2), either blank or having the actual pattern (6), said pattern (6) comprising absorbing and/or phase-shifting materials,
b) providing a light source (8) for generating a light beam (10) for scanning the sample (2) in transmission mode or reflection mode;
c) illuminating the sample (2) with the light beam (10), preferably under an angle of 0 to 45° relative to the surface normal of the sample, thereby diffracting the light beam (10) according to the actual pattern (6) present on the sample (2);
d) detecting the diffracted light beam (11) in terms of its position related intensities with a position sensitive detector (12);
e) analyzing the detected intensities, and thereby obtaining a reconstructed diffraction image responsive to the actual pattern (6) of the sample (2);
f) calculating a predicted diffraction image of the desired pattern, preferably using Fourier or Fresnel calculations;
g) comparing the reconstructed diffraction image with the predicted diffraction image for the detection of an intensity variation deviating from the predicted diffraction image; and
h) identifying the position of the deviating intensity variation for further inspection this position of the sample (2).

## Description

The present invention relates to a method using scanning CDI techniques for the identification of defects in an actual pattern of a sample as compared to the desired pattern of the sample.

Photolithograhy is a commonly used method for the production of micro and nanostructures used in integrated circuit technology and other commercial applications. Photolithography includes but not limited to DUV (193 nm), DUV immersion, EUV (13.5 nm), BEUV (6.x nm) and X-rays. It is done using projection optics in which structures on a photo-mask are projected onto a wafer. Photo-masks must be with low defect density, and ideally free of defects over several cm². Therefore photo-mask making involves multiple steps of inspection, review, and repair. The metrology methods and tools for sensitive and rapid identification and characterization of defects on mask blanks and patterned masks are therefore of great importance. Although different tools such as SEM and AFM are helpful, actinic metrology, i.e. optical inspection/review at the same wavelength and illumination conditions of a scanner is indispensable.

Particularly challenging is the actinic mask inspection of EUV lithography, which is the most promising route to face challenges of the semiconductor industry for high-volume manufacturing at the technology nodes below 22 nm. One of the major challenges of the EUV lithography is the provision of the masks with low defect density. Currently, there is a great and immediate need for such tools to detect and analyze phase and amplitude defects on mask blanks (multilayers) and patterned masks. The defects on the multilayer are mainly amplitude defects whereas the ones under the multilayer are purely phase defects. The defects within the multilayer lead to both undesired phase and amplitude modulation.

By inspection, metrology methods for mask review/inspection/characterization/evaluation of the masks are meant to be used for lithography. The aims include, but not limited to, obtaining the areal image of the mask, identification of the defects and their characterization.

By mask blank, it is meant a transparent (a quartz plate for DUV) and reflective substrate (Bragg multilayer for EUV and soft X-rays). A patterned mask is for example the photo-mask after the designed patterns are written on the substrate using absorber or phase-shifting materials for the artefacts of the pattern. The feature size of the patterns is 4 or 5 times larger than the desired pattern on the wafer. This means, for instance, for 11 nm technology node the minimum feature size will be 44 nm.

The aims of inspection tasks may be different such as determination of defect density of mask blanks, identification of the defects (phase, amplitude, size, type of defect), comparison of defect density of blanks which went through different preparation or cleaning process, evaluation of a certain cleaning process if it is successful for removal of a previously identified defect, etc.

By actinic inspection, it is meant that the inspection is performed at wavelength and relevant incidence angle of the light. For EUV mask, this must be reflective and at incidence angle of 6 degrees at 13.5 nm wavelength. This is the standard condition for the use of the masks in real operation, i.e lithographic production of semiconductor devices.

For an inspection tool, the following features or aspects are important:
1) Resolution is critical in order to resolve all the defects that contribute to the patterning in the lithographic process and thereby deteriorate the yield in fabrication process. On the other hand, for practical applications, it might be sufficient just to locate the defect, which may not require such a high resolution. For some purpose, even higher resolution might be necessary. For instance, to investigate the effects of line-edge roughness and tiny defects.
2) Throughput is the most important parameter in practical applications. Since the mask sizes are relatively large (> 100 mm²), fact identification of defects with nanometer resolution is a great challenge. Since the detection is generally done with a CCD, a detector-limited throughput can be defined: Namely collection time from a spot size (resolution x pixel number) takes less than the read-out time.
3) Characterization of the defects. Sensitivity to certain type of defects, signal-to-noise, independent characterization of amplitude and phase defects are among the issues one should consider.
4) Navigation and flexibility. Fast navigation, exact location of the defects with respect to alignment markers, easy switching between the options of different throughput and resolution are also as important as other parameters.
5) Moreover, cost of ownership, cost of maintenance, reliability, up-time are also important aspects.

It is therefore the objective of the present invention to provide a method and a system that allow to analyze the structure of the pattern of a sample for errors/defects using a rather simple set-up having a high throughput and sensitivity.

With respect to the method, this objective is achieved according to the present invention by a method for scanning CDI for the identification of defects in an actual pattern of a sample as compared to the desired pattern of the sample, said method comprising the steps of:
a) providing the sample, either blank or having the actual pattern, said pattern comprising absorbing and or phase-shifting materials,
b) providing a light source for generating a light beam for scanning the sample in transmission mode or reflection mode;
c) illuminating the sample with the light beam, preferably under an angle of 0 to 45° relative to the surface normal of the sample, thereby diffracting the light beam according to the actual pattern present on the sample;
d) detecting the diffracted light beam in terms of its position related intensities with a position sensitive detector;
e) analyzing the detected intensities, and thereby obtaining a reconstructed diffraction image of the actual pattern of the sample;
f) calculating a predicted diffraction image of the desired pattern, preferably using Fourier or Fresnel calculations;
g) comparing the reconstructed diffraction image with the predicted diffraction image for the detection of an intensity variation deviating from the predicted diffraction image; and
h) identifying the position of the deviating intensity variation for further inspection this position of the sample.

With respect to the system, this objective is achieved according to the present invention by a system for scanning CDI for the identification of defects in an actual pattern of a sample as compared to the desired pattern of the sample, said system comprising:
a) a sample holder for holding the sample being either blank or having the actual pattern, said pattern comprising absorbing and or phase-shifting materials,
b) a light source for generating a light beam for scanning the sample in transmission mode or reflection mode thereby illuminating the sample with the light beam, preferably under an angle of 0 to 45° relative to the surface normal of the sample;
d) a position sensitive detector for detecting the diffracted light beam in terms of its position related intensities;
e) means for data processing for analyzing the detected intensities in order to obtain a reconstructed diffraction image of the actual pattern of the sample;
f) means for calculating a predicted diffraction image of the desired pattern, preferably using Fourier or Fresnel calculations;
g) means for comparing the reconstructed diffraction image with the predicted diffraction image for the detection of an intensity variation deviating from the predicted diffraction image; and
h) means for identifying the position of the deviating intensity variation for further inspection this position of the sample.

Therefore, the method and the system for the coherent diffraction imaging (sometimes also synonymously called coherent scattering microscopy) uses the recorded (detected) diffraction profile at the detector and special known algorithms in order to reconstruct the image of the sample and compares this reconstructed image to the predicted image which has been calculated according to the known desired pattern/structure of the sample. The present invention therefore proposes a novel techniques for lens-less, high-resolution and reflective imaging of samples using scanning CDI; as well as detecting the defects by analyzing the detected intensities by looking at their difference from the expected intensities which can be called *differential CDI.* Compared to the imaging methods with optics, both amplitude and phase are extracted simultaneously with a 2D scan whereas optics-based imaging requires through-focus, i.e. 3D scan, in order to reconstruct the phase. Moreover, depth of focus is not critical compared to imaging with optics. Therefore, for structured samples (i.e. masks), a fast inspection can be executed on the comparison of the effective diffraction pattern of the sample and the diffraction pattern deducted from the desired pattern. Subject of the present invention is that the investigation for only deviations from the expected diffraction pattern will allow rapid identification of the defects on the actual pattern of the sample.

The present invention may have a broad range of applications since the light source may provide visible light or UV light, DUV light, EUV light, soft X-rays or hard X-rays depending on the spatial resolution to be achieved.

Typically, the actual pattern may be a structure of an electronic circuitry in a semiconductor chip, such as an array of transistors, resistances, inductivities and/or capacitances. This structure is engineered according to the needs and the desired functionality of the semiconductor chip, such as a processor or a mass storage device. Therefore, the desired pattern in this sense is identical to the engineered pattern of the sample.

In specific set-ups, the detected intensities can be analyzed using a ptychographic algorithm, such as Fourier back transform algorithms.

The present invention and its preferred embodiment are hereinafter described in more detail with reference to the attached drawings which depict in:
- Figure 1: schematically the method of the inspection of a patterned sample according to the differential CDI technique in transmission mode; and
- Figure 2: schematically the method of the inspection of a patterned sample according to the differential CDI technique in reflection mode.

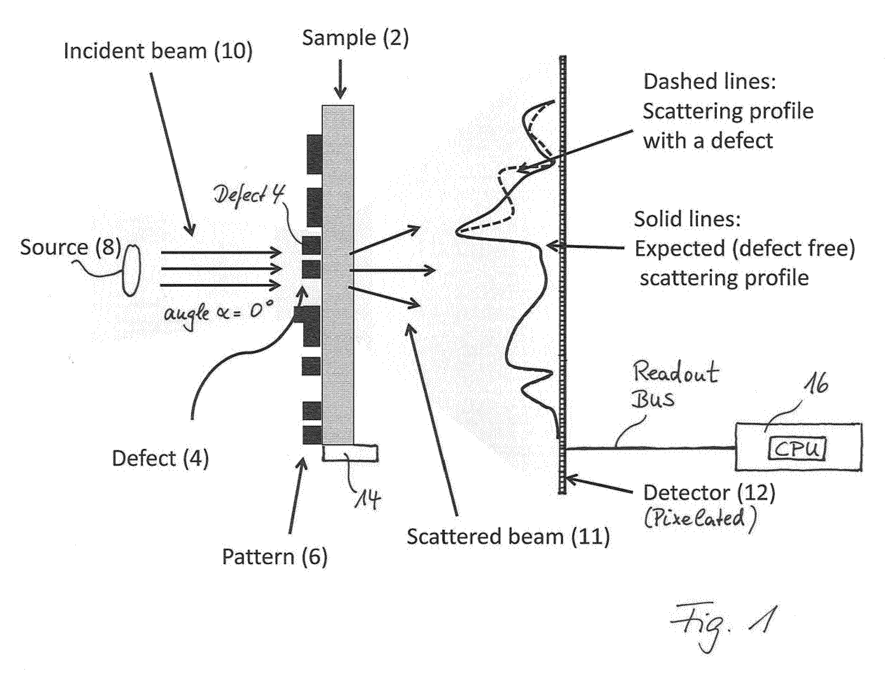

Figure 1 schematically illustrates the concept of the present invention involving a method and a system of analyzing or inspecting samples 2 for defects 4 in transmission mode. In many cases, including but not limited to, the major interest is locating the defects 4 and their characterization. A defect 4 is a void or particle perturbing an intended (desired) pattern 6 or on a flat surface of a blank sample. A fast inspection of the samples 2 with high sensitivity is needed. In the example according to Figure 1, a pattern 6 is shown which comprises an ensemble of absorbing or phase shifting artefacts disposed on the surface of the sample 2. One of artefacts is designated a defect 4 because this artefact is not projected in the desired pattern but is erroneously present in the actual pattern 6. The artefacts and its arrangement correspond for example to a final illumination pattern of a wafer surface that can be made subject to an etching step or the like in CMOS wafer production in semiconductor industry. Therefore, the pattern 6 is usually internally irregular (no periodicity within the pattern 6). In wafer production, the mask used for the illumination of the wafer may comprise this pattern repeatedly disposed over the mask surface which yields to a periodicity of the pattern (the pattern is repeated at an integer number of times over the surface of the wafer mask).

The proposed method is a technique in which a diffraction profile is recorded with a position sensitive detector, such as a pixel detector 12 (also called pixelated detector 12). It has to be pointed out that the terms "diffraction" and "scattering" are synonymously used in this text. The sample 2 is either blank or patterned with absorbing or phase-shifting materials (see the pattern 6 on the surface of the sample 2). It has to be mentioned here that the pattern 6 might have a certain periodicity wherein the pattern 6 itself is usually heterogeneously (irregular), i.e. the pattern of an individual storage cell. This may for example apply to a certain structure in CMOS technology (i.e. an array of transistors) that is numerously repeated on the surface of the sample 2 used as a mask for wafer production. In this case, the pattern 6 is internally non-periodic, but the whole pattern 6 is repeated numerously on the surface of the wafer mask.

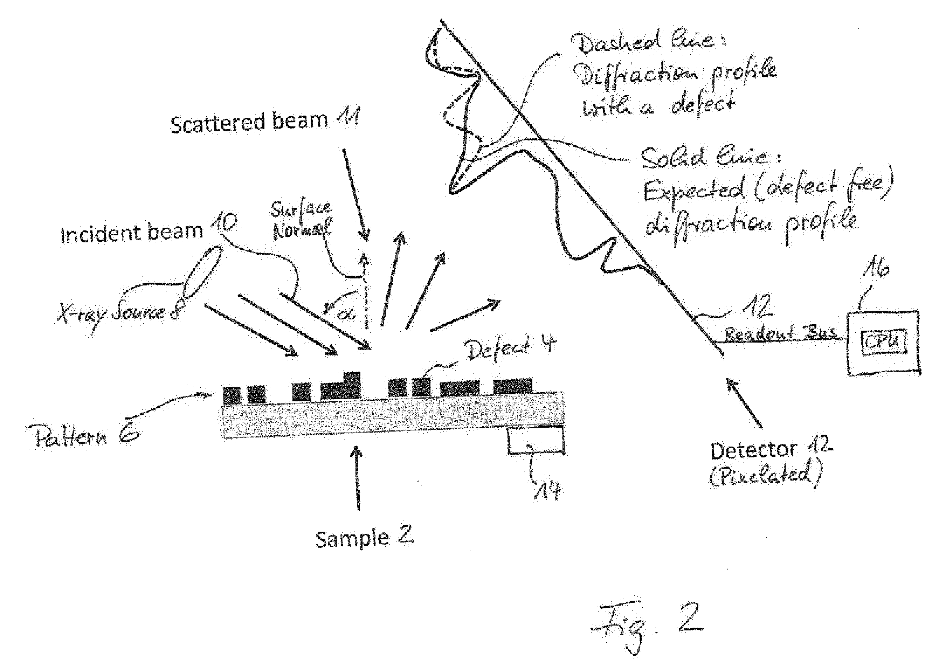

Due to disadvantageous circumstances during sample production, the desired or engineered pattern may not be identically transferred to the sample, i.e. a wafer mask, (some areas comprise correct copies of the desired pattern, others may comprise patterns with defects, such as the pattern 6 shown with the defect 4 in Figures 1 and 2) resulting therefore in a faulty wafer production. Since the desired pattern is known and the diffraction image of this desired pattern can be calculated, for example by using Fourier or Fresnel algorithms, the images of the detected diffraction light intensities can be compared to the calculated diffraction image of the desired pattern. When this comparison yields a deviation (image mismatch as shown in Figures 1 and 2 as deviation of the dashed line from the solid line) indicative for a defect in the pattern 6 of the sample 2, a candidate region for further sample inspection has been identified. This situation is represented in Figures 1 and 2 where the intensity distribution of the detected image (dashed line) does not match the expected intensity distribution (solid line) due to the undesired artefact (defect 4) causing a deviating intensity distribution.

In Figure 1, the light source is an X-ray source 8 (such as from a synchroton source or a high-harmonic generation) illuminating the surface of the sample 2 being supported by a sample holder 14 with a coherent light beam 10. The light source in this example is an X-ray source. In other setups, the light source could be a source for emitting visible light or UV or DUV or EUV or soft or hard X-rays. The diffracted beam 11 responsive to the pattern 6 disposed on the sample 2 in this example is recorded in transmission mode by the pixel detector 12 (the setup in Figure 2 show coherent diffraction imaging in reflection mode). Since the pattern 6 on the sample 2 is known a priori or since it is known that there should be no pattern in case of a blank sample and the respective diffraction profiles are predicted at the detector plane using Fourier or Fresnel calculations. The detected diffraction profile is compared with the predicted diffraction profile. If the profiles do not match, this indicates a defect, and thus its position is located. This evaluation is done in a data processing unit 16 which is connected via a readout bus to the pixelated detector 12.

Once the defect is located, it can be characterized in detail by using coherent scattering microscopy algorithms with the already collected data or with subsequently collecting more detailed data of diffraction profile. This method is called differential coherent diffraction imaging (CDI) which is a lens-less, high-resolution inspection using scanning CDI and enables identification and location of defects 4 on samples 2. Subject of the present invention is that the investigation for only deviations from the normal expected diffraction image will allow rapid identification of the defects 4 on patterns 6 that are known or predicted a priori. One advantage of this method is that it is faster than other imaging methods, in the case that inspection speed is limited by the detector read out speed. In many cases, the pattern 6 are well-known and periodic (in short range or long range) as well as there are mostly certain types of defects expected on the sample 2. The detector read out area can be limited to the areas where the scattering profile has the highest sensitivity to the defects.

Ptychographic algorithms are used in this technique aiming to solve the diffraction-pattern phase problem by interfering adjacent Bragg reflections coherently and thereby determine their relative phase. In the original formulation, it was envisaged that such interference could be effected by placing a very narrow aperture in the plane of the sample so that each reciprocal-lattice point would be spread out and thus overlap with one another. The name ptychography, from the Greek for *fold,* derives from this optical configuration; each reciprocal lattice point is convolved with some function, and thus made to interfere with its neighbors. In fact, measuring only the intensities of interfering adjacent diffracted beams still leads to an ambiguity of two possible complex conjugates for each underlying complex diffraction amplitude. The original formulation of ptychography is equivalent to the well known theorem that for a finite specimen (that is one delineated by a narrow aperture, sometimes known as a *finite support*), the one dimensional phase problem is soluble to within an ambiguity of 2N, where N is the number of Fourier components that make up the specimen. However, such ambiguities may be resolved by changing the phase, profile or position of the illuminating beam in some way. The fact that not only the intensities of the diffracted beams but also the intensities lying midway between the beams, where the convolved Bragg beams interfere, is an alternative statement of the Nyquist-Shannon sampling theorem for components of diffracted intensity. These components generally have twice the frequency (in reciprocal space) of their underlying complex amplitudes.

Ptychographic imaging along with advances in detectors and computing have resulted in X-ray microscopes, optical and electron microscopy with increased spatial resolution without the need for lenses.

Therefore, ptychographic imaging is a CDI method based on scanning with oversampling (Scanning step width is usually five to ten times smaller than the diameter of the coherent light beam). It enables high-resolution imaging without optics. It provides both amplitude and phase information of the specimens. Since this method is a coherent imaging method, it has stringent requirements on spatial and temporal coherence. The resolution is limited by the NA of the detector and accuracy of the stage. With high-NA Fourier transform imaging 90 nm resolution has been demonstrated at a wavelength of 29 nm. The resolution was improved by using an iterative Fourier phase retrieval method down to 50 nm.

The present invention proves the potential of ptychographic methods for high-resolution imaging in EUV and soft X-ray range. In principle, ptychography can be used for EUV mask inspection. Following advantages can be listed:
1. Resolution is not limited with optics: detector limited resolution for spot size is possible. High NA EUV optics is very expensive, making high-resolution inspection tools costly.
2. Throughput (spot size) is not limited with optics (sweet spot, aplanarity). In principle detector limited throughput can be possible, i.e. the time budget is mainly consumed by read-out time of the detector and collection time is insignificant.
3. Depth of focus is not critical.
4. Both amplitude and phase information is obtained. This is particularly important for EUV masks, because the phase defects are difficult to obtain. Phase information can be obtained using optics and through-focus scans. This however reduces the throughput of the imaging, which is very important for EUV mask metrology.
5. It is advantageous over other holographic methods. Since it does not require a priori knowledge of the illumination or reference beam or reference frame/pattern in order to reconstruct the image. Therefore, it is more flexible and imaging area is not limited.

The present invention proposes the novel technique of *differential CDI.* For periodically structured masks that means that the masks may comprise regions where the local pattern is repeated without having an internally periodic pattern, a fast inspection can be executed by steps of multiples of period, which should give the same diffraction pattern. Subject of the present invention is that the investigation for only deviation from the expected diffraction pattern will allow rapid identification of the defects on some pattern which are repeated periodically over the mask surface. After the identification of the defects, these areas of interest can be analyzed in detail and the image can be reconstructed using ptychograhy.

Figure 2 shows the corresponding configuration for reflective imaging using scanning CDI. In this example, the light beam 10 illuminates the surface of the sample 2 under an angle α. Typically in EUV applications is an angle of 6°. This angle α can be different in other applications according to the specific needs and set-ups.

It is noted that in all the figures, CCD refers to any type of pixelated detector and not limited to soft X-ray CCDs.

Further, it is noted that the methods and setups disclosed in this invention are also valid at other wavelengths such as UV, DUV, BEUV and soft X-rays. For structured samples, such as masks for wafer production, with a periodicity of an heterogeneous pattern 6, a fast inspection can be executed by steps of multiples of period, which should give the same diffraction image responsive to the repeatedly disposed pattern 6. Subject of the present invention is that the investigation for only deviation from the normal diffraction image responsive to the pattern 6 will allow rapid identification of the defects on periodic mask patterns. Compared to other CDI methods, a priori knowledge of the illumination is not needed. Both amplitude and phase are extracted whereas optics-based imaging requires through-focus imaging in order to reconstruct the phase.

In the following, the main method steps are summerized: First, the sample 2, either blank or having the actual pattern 6, is provided wherein said pattern 6 comprising absorbing and/or phase-shifting materials. Second, a light source 8 for generating a light beam 10 for scanning the sample 2 in transmission mode or reflection mode is provided. After that, the sample 2 is illuminated with the light beam 10, perferably under an angle of 0 to 45° relative to the surface normal of the sample according to the desired set-up and wavelength of the light source 8, thereby diffracting the light beam 10 according to the actual pattern 6 present on the sample 2. During this illumination step the sample 2 is scanned over the desired surface area at discrete positions by the light beam 10. For each position, the diffracted light beam (11) is detected in terms of its position related intensities with a position sensitive detector 12. The detected intensities are then analyzed thereby obtaining a reconstructed diffraction image responsive to the actual pattern 6 of the sample. Due to the known or expected pattern a predicted diffraction image of the desired pattern is calculated, for example by using Fourier or Fresnel calculations. Finally, the reconstructed diffraction image is compared to the predicted diffraction image for the detection of an intensity variation deviating from the predicted diffraction image. The position of the deviating intensity variation is identified for further inspecting this position of the sample 2 in order to understand the nature and characteristics of the defect.

## Claims

1. A method for scanning CDI for the identification of defects (4) in an actual pattern (6) of a sample (2) as compared to the desired pattern of the sample (2), said method comprising the steps of:
a) providing the sample (2), either blank or having the actual pattern (6), said pattern (6) comprising absorbing and/or phase-shifting materials,
b) providing a light source (8) for generating a light beam (10) for scanning the sample (2) in transmission mode or reflection mode;
c) illuminating the sample (2) with the light beam (10), preferably under an angle of 0 to 45° relative to the surface normal of the sample, thereby diffracting the light beam (10) according to the actual pattern (6) present on the sample (2);
d) detecting the diffracted light beam (11) in terms of its position related intensities with a position sensitive detector (12);
e) analyzing the detected intensities, and thereby obtaining a reconstructed diffraction image responsive to the actual pattern (6) of the sample (2) ;
f) calculating a predicted diffraction image of the desired pattern, preferably using Fourier or Fresnel calculations;
g) comparing the reconstructed diffraction image with the predicted diffraction image for the detection of an intensity variation deviating from the predicted diffraction image; and
h) identifying the position of the deviating intensity variation for further inspection this position of the sample (2).

2. The method according to claim 1, wherein the light source (8) provides visible light or UV light, DUV light, EUV light, soft X-rays or hard X-rays.

3. The method according to claim 1 or 2, wherein the actual pattern (6) is a structure of an electronic circuitry in a semiconductor chip.

4. The method according to any of the preceding claims, wherein the desired pattern is the engineered pattern of the sample (2).

5. The method according to any of the preceding claims, wherein the detected intensities are analyzed using a ptychographic algorithm.

6. A system for scanning CDI for the identification of defects (4) in an actual pattern (6) of a sample (2) as compared to the desired pattern of the sample (2), said system comprising:
a) a sample holder (14) for holding the sample (2) being either blank or having the actual pattern, said pattern comprising absorbing and or phase-shifting materials,
b) a light source (8) for generating a light beam (10) for scanning the sample (2) in transmission mode (Fig. 1) or reflection mode (Fig. 2) thereby illuminating the sample (2) with the light beam (10), preferably under an angle of 0 to 45° relative to the surface normal of the sample;
d) a position sensitive detector (12) for detecting the diffracted light beam in terms of its position related intensities;
e) means (16) for data processing for analyzing the detected intensities in order to obtain a reconstructed diffraction image of the actual pattern of the sample;
f) means (16) for calculating a predicted diffraction image of the desired pattern, preferably using Fourier or Fresnel calculations;
g) means (16) for comparing the reconstructed diffraction image with the predicted diffraction image for the detection of an intensity variation deviating from the predicted diffraction image; and
h) means (16) for identifying the position of the deviating intensity variation for further inspection this position of the sample (2).

7. The system according to claim 6, wherein the light source provides visible light or UV light, DUV light, EUV light, soft X-rays or hard X-rays.

8. The system according to claim 6 or 7, wherein the detected intensities are analyzed using a ptychographic algorithm.

9. The system according to any of the preceding claims 6 to 8, wherein the data processing means, the calculations means, the comparing means and the identifying means are provided by a common data processing unit (16).
